(19) **Europäisches Patentamt European Patent Office Office européen des brevets**

(11) **EP 4 780 187 A1**

(12) **EUROPEAN PATENT APPLICATION**
published in accordance with Art. 153(4) EPC

(43) Date of publication:
**22.07.2026 Bulletin 2026/30**

(21) Application number: **24865724.9**

(22) Date of filing: **27.08.2024**

(51) International Patent Classification (IPC):
**H10N 97/00** (2023.01)     **H10D 86/80** (2025.01)
**H10D 84/00** (2025.01)

(52) Cooperative Patent Classification (CPC):
**H10D 84/00; H10D 86/80; H10N 97/00**

(86) International application number:
**PCT/KR2024/012792**

(87) International publication number:
**WO 2025/058283 (20.03.2025 Gazette 2025/12)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **11.09.2023 KR 20230120435**

(71) Applicant: **LG Innotek Co., Ltd.**
**Seoul 07796 (KR)**

(72) Inventors:
• **LEE, Tae Jin**
  **Seoul 07796 (KR)**
• **SON, Kwan Young**
  **Seoul 07796 (KR)**
• **LEE, Jong Sik**
  **Seoul 07796 (KR)**

(74) Representative: **DREISS Patentanwälte PartG mbB**
**Friedrichstraße 6**
**70174 Stuttgart (DE)**

(54) **CAPACITOR**

(57) A capacitor according to one embodiment of the present invention includes: a base substrate including a plurality of through-holes penetrating from a first surface to a second surface opposite to the first surface; a base electrode disposed on the first surface to cover at least two adjacent through-holes among the plurality of through-holes; a first electrode layer disposed on an upper surface edge and a side surface of the base electrode; a dielectric layer disposed on the first electrode layer; a second electrode layer disposed on the dielectric layer; an insulating layer disposed on the second electrode layer; and a first electrode pad disposed on an upper surface of the base electrode, wherein the insulating layer extends from an upper surface of the second electrode layer along a side surface of the second electrode layer, a side surface of the dielectric layer, and a side surface of the first electrode layer to the upper surface of the base electrode, and is disposed between a side surface of the first electrode pad and the side surface of the first electrode layer, the side surface of the dielectric layer, and the side surface of the second electrode layer.

FIG. 7

## Description

[Technical Field]

An embodiment of the present invention relates to a capacitor.

[Background Art]

Semiconductor packages are applied to various fields such as vehicles, communications, and computers, and generally include a printed circuit board, a semiconductor chip disposed on the printed circuit board, and a passive element disposed on the printed circuit board. The passive element may include, for example, a resistor, an inductor, a capacitor, etc.

As semiconductor packages become more advanced, demands for capacitors having high performance, high reliability, and ultra- small size have been increasing. In order to satisfy such demands, silicon-based capacitors and anodic aluminum oxide (AAO)-based capacitors have been proposed. The silicon-based capacitor includes an electrode layer, a dielectric layer, and an electrode layer that are sequentially stacked on a silicon base, and the AAO-based capacitor includes an electrode layer, a dielectric layer, and an electrode layer that are sequentially stacked on an AAO base.

The AAO base may be a porous substrate fabricated by a metal anodization process. Since the porous substrate has a large surface area, the capacitance of the capacitor may be increased. However, there is a problem in that a process of disposing an electrode pad on the porous substrate is highly difficult.

[Disclosure]

[Technical Problem]

A technical object to be achieved by the present invention is to provide an ultra-small and high-capacitance capacitor.

[Technical Solution]

A capacitor according to one embodiment of the present invention includes: a base substrate including a plurality of through-holes penetrating from a first surface to a second surface opposite to the first surface; a base electrode disposed on the first surface to cover at least two adjacent through-holes among the plurality of through-holes; a first electrode layer disposed on an upper surface edge and a side surface of the base electrode; a dielectric layer disposed on the first electrode layer; a second electrode layer disposed on the dielectric layer; an insulating layer disposed on the second electrode layer; and a first electrode pad disposed on an upper surface of the base electrode, wherein the insulating layer extends from an upper surface of the second electrode layer along a side surface of the second electrode layer, a side surface of the dielectric layer, and a side surface of the first electrode layer to the upper surface of the base electrode, and is disposed between a side surface of the first electrode pad and the side surface of the first electrode layer, the side surface of the dielectric layer, and the side surface of the second electrode layer.

A side surface of the base electrode may be disposed to be inclined with respect to the first surface, and the first electrode layer disposed on the side surface of the base electrode may be disposed to be inclined with respect to the first surface.

The side surface of the base electrode may include a concave region, and the first electrode layer may be disposed along the concave region on the side surface of the base electrode.

A lower surface of the base electrode may include a protrusion protruding in a direction from the first surface toward the second surface within the at least two through-holes.

The at least two through-holes disposed under the base electrode may be empty.

Remaining through-holes of the plurality of through-holes, excluding the at least two through-holes, may be filled by the first electrode layer, the dielectric layer, the electrode layer, and the insulating layer.

The first electrode layer, the dielectric layer, the second electrode layer, and the insulating layer may be sequentially disposed on an inner wall surface of the remaining through-holes of the plurality of through-holes, excluding the at least two through-holes.

The first electrode layer, the dielectric layer, and the second electrode layer may be sequentially disposed on the first surface of the base substrate in a second region around a first region in which the base electrode is disposed and may further include a second electrode pad disposed on the second electrode layer in the second region.

A thickness of the base electrode may be 0.9 to 1.1 times a thickness of the first electrode layer, the dielectric layer, and the second electrode layer disposed in the second region.

The thickness of the base electrode may be 10 nm to 100 $\mu$m.

A diameter of each of the plurality of through-holes may be 10 nm to 500 nm, the shortest distance between two through-holes may be 10 nm to 500 nm, and an aspect ratio of the respective through-holes may be 20 or greater.

The base substrate may be an anodized substrate of at least one of aluminum (Al), magnesium (Mg), zinc (Zn), titanium (Ti), tantalum (Ta), hafnium (Hf), or niobium (Nb).

[Advantageous Effects]

According to an embodiment of the present invention, it is possible to provide an ultra-small and high-capacitance capacitor. In addition, according to an embodiment of the present invention, a capacitor having a simple fabrication process, low cost, and high reliability may be provided. In particular, according to an embodiment of the present invention, a capacitor having a simple process for connecting electrode pads can be provided.

[Description of Drawings]

FIG. 1 is a perspective view of a capacitor according to an embodiment of the present invention.
FIG. 2 is a perspective view of a base substrate included in the capacitor according to an embodiment of the present invention.
FIG. 3 is a top view of the base substrate included in the capacitor according to an embodiment of the present invention.
FIG. 4 is a cross-sectional view of the base substrate included in the capacitor according to an embodiment of the present invention.
FIG. 5 is a top view of the base substrate and the base electrode included in the capacitor according to an embodiment of the present invention.
FIG. 6 is a cross-sectional view of the base substrate and the base electrode included in the capacitor according to an embodiment of the present invention.
FIGS. 7 to 12 are cross-sectional views of the capacitor according to an embodiment of the present invention.
FIG. 13 is an example of a manufacturing method of a base substrate according to an embodiment of the present invention.

[Modes of the Invention]

Hereinafter, exemplary embodiments of the present invention will be described in detail with reference to the accompanying drawings.
However, the spirit of the present invention is not limited to the embodiments described below, and the present invention may be embodied in various forms. One or more components of the embodiments may be selectively combined or substituted with one another within the spirit or scope of the present invention.
In addition, the terminology used in the embodiments of the present invention, including technical and scientific terms, unless explicitly defined otherwise, shall be interpreted as having meanings that are generally understood by those of ordinary skill in the art to which the present invention pertains, and terms having meanings commonly understood, such as those defined in dictionaries, shall be interpreted in the context of the related technologies.
In addition, the terminology used in the embodiments of the present invention is used for the purpose of describing the embodiments only and is not intended to limit the scope of the present invention.
In the present specification, the singular forms can be understood to include plural forms unless otherwise indicated, and the expression "at least one of A, B, and/or C" can be understood to include any combination of one or more A, B, and C.
In addition, expressions such as "first," "second," "A," "B," "(a)," and "(b)," may be used to describe components of embodiments of the present invention.
These expressions are used solely to distinguish one component from another, and do not limit the substance, order, or arrangement of the corresponding components.
Furthermore, when an component is described as being "connected," "combined," or "accessed" to another component, the description should be understood to include that the component is "connected," "combined," or "accessed" to the other component not only directly, but also indirectly through one or more intervening components.
In expression "formed or disposed "on (over) or under (below)" another component," the terms "on (over)" and "under (below)" include not only a direct contact between two components, but also formation or disposition in which one or more other components are interposed between the two components. Furthermore, the terms "on (over)" and "under (below)" may refer to both upper and lower directions relative to one component.
Hereinafter, embodiments of the present invention will be described in detail with reference to the accompanying drawings. The same reference numerals refer to the same or corresponding components throughout the drawings, and redundant descriptions thereof will be omitted.

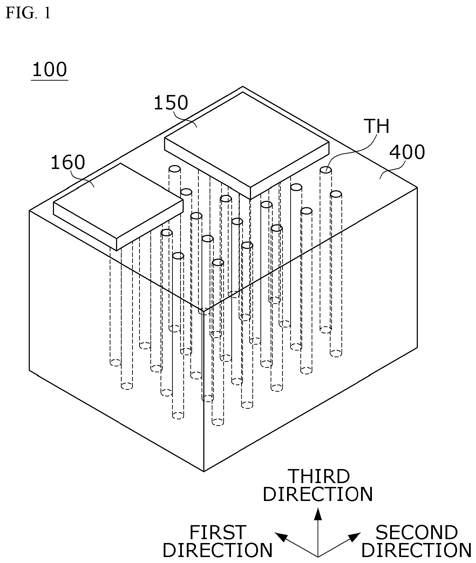

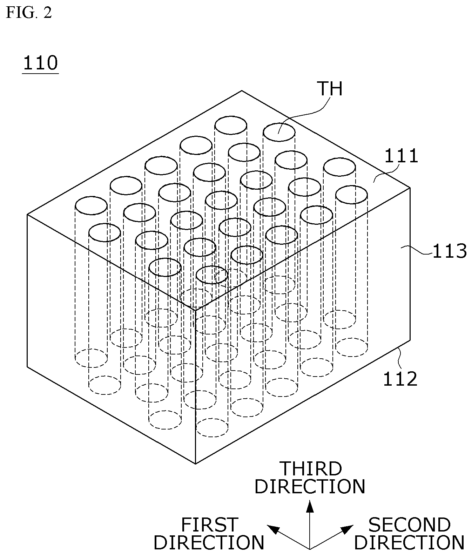

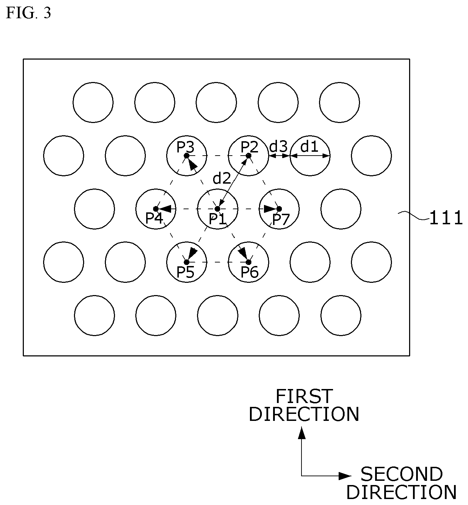

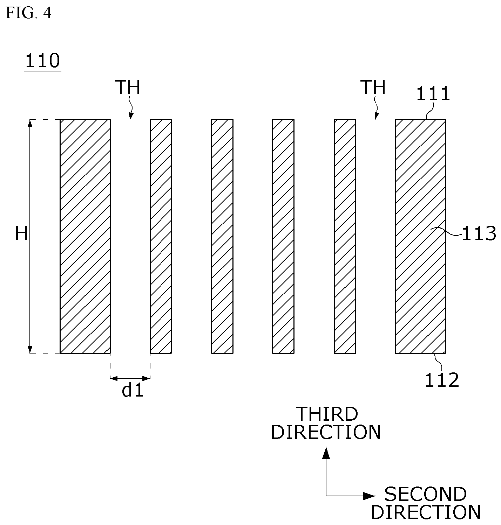

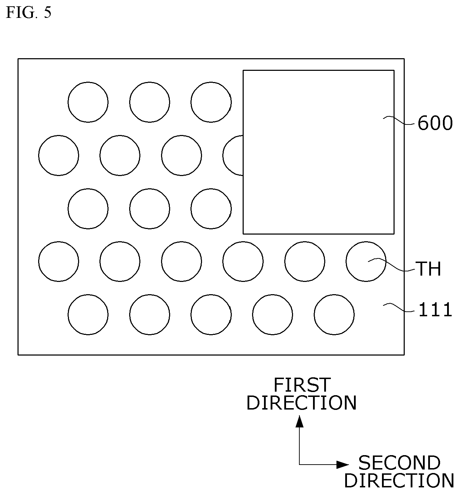

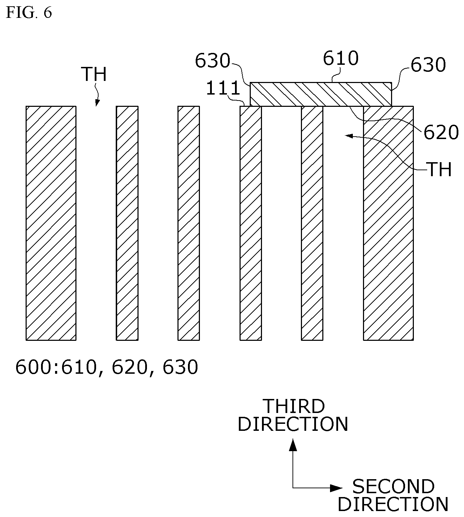

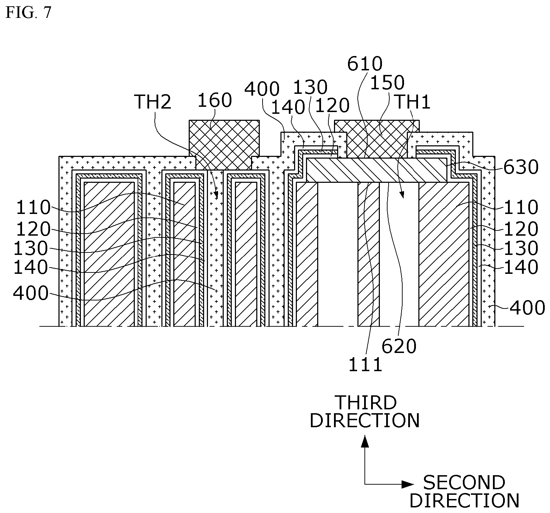

FIG. 1 is a perspective view of a capacitor according to an embodiment of the present invention, FIG. 2 is a perspective view of a base substrate included in the capacitor according to an embodiment of the present invention, FIG. 3 is a top view of the base substrate included in the capacitor according to an embodiment of the present invention, FIG. 4 is a cross-sectional view of the base substrate included in the capacitor according to an embodiment of the present invention, FIG. 5 is a top view of the base substrate and the base electrode included in a capacitor according to an embodiment of the present invention, FIG. 6 is a cross-sectional view of the base substrate and the base electrode included in a capacitor according to an embodiment of the present invention, and FIGS. 7 to 12 are cross-sectional views of the capacitor according to an embodiment of the present invention.

Referring to FIGS. 1 to 12, a capacitor 100 includes a base substrate 110, a first electrode layer 120, a first dielectric layer 130, and a second electrode layer 140.

As shown in FIGS. 2 to 4, the base substrate 110 includes a first surface 111, a second surface 112 opposite to the first surface 111, and a third surface 113 disposed between the first surface 111 and the second surface 112. The first surface 111, the second surface 112, and the third surface 113 may be referred to as an upper surface, a lower surface, and a side surface, respectively. The base substrate 110 is illustrated as having a hexahedral shape, but is not limited thereto. The substrate 110 may be a cylinder, an elliptical cylinder, a prism, or the like.

The base substrate 110 may include a semiconductor material or a non-conductor material. For example, the base substrate 110 may include an anodized metal. For example, the base substrate 110 may be an anodized substrate of at least one of aluminum (Al), magnesium (Mg), zinc (Zn), titanium (Ti), tantalum (Ta), hafnium (Hf), or niobium (Nb). For example, the base substrate 110 may include anodic aluminum oxide (AAO). Alternatively, the base substrate 110 may be a silicon (Si) substrate. For example, the base substrate 110 may be a doped silicon substrate. For example, the base substrate 110 may be an n-type doped silicon substrate or a p-type doped silicon substrate.

According to an embodiment of the present invention, the base 110 includes a plurality of through-holes TH penetrating from the first surface 111 to the second surface 112. In other words, the plurality of through-holes TH extend from the first surface 111 of the base 110 to the second surface 112. In this case, at least some of the plurality of through-holes TH may be parallel to each other. For example, an imaginary line connecting from the center of a bottom surface to the center of an upper surface of one of the plurality of through-holes TH may be parallel to an imaginary line connecting from the center of an upper surface to the center of the upper surface of another one of the plurality of through-holes TH. According to the embodiment, since an electrode layer may be easily deposited with a uniform thickness on inner wall surfaces of the plurality of through-holes TH, a high-reliability capacitor may be acquired. The plurality of through-holes TH may be regularly arranged. For example, as illustrated in FIG. 3, distances from a center point P1 of one through-hole to center points P2-P7 of six through-holes arranged to surround the same are constant, and when the center points P2-P7 of the six through-holes are imaginarily connected, they may be arranged to have a hexagonal shape. In this case, a deviation in a diameter d1 of the plurality of through-holes TH may be within 25%. Alternatively, a deviation in a distance d2 between center points of adjacent through-holes among the plurality of through-holes TH may be within 25%. Herein, the deviation may refer to a deviation between a minimum value and a maximum value. In other words, the maximum value of the diameter of the through-holes or the distance between the center points may mean that it is 1.25 times or less than the minimum value of the diameter of the through-holes or the distance between the center points. Alternatively, the deviation may refer to a deviation from an average value. In other words, the diameter of the through-holes or the distance between the center points may mean that it is within 75% to 125% of the average value of the diameter of the through-holes or the distance between the center points. As such, when the plurality of through-holes TH are regularly arranged, the surface area of the base substrate 110 is kept constant, so that a capacitor with uniform quality may be obtained.

According to an embodiment of the present invention, an average diameter d1 of the plurality of through-holes TH may be 1 nm to 1 $\mu$m, preferably 10 nm to 500 nm, and more preferably 50 nm to 300 nm. Alternatively, an average shortest distance d3 between two adjacent through-holes TH may be 1 nm to 1 $\mu$m, preferably 10 nm to 500 nm, and more preferably 50 nm to 300 nm. According to the embodiment, it is possible to minimize a possibility of damage to the base substrate 110 and increase durability while securing a sufficient specific surface area for implementing a capacitor.

In this case, an aspect ratio of the respective through-holes TH may be 20 or more, preferably 40 or more, more preferably 60 or more, and even more preferably 80 or more. Here, the aspect ratio may refer to a ratio of a height H of the through-holes TH with respect to the second surface 112 of the base substrate 110 to the diameter d1 of the through-holes TH. According to the embodiment, it is possible to obtain a capacitor having a high capacity by maximizing the surface area of the base substrate 110.

Meanwhile, as shown in FIGS. 5 to 6, the capacitor 100 according to an embodiment of the present invention further includes a base electrode 600. The base electrode 600 is disposed on the first surface 111 of the base substrate 110 to cover at least two adjacent through-holes among the plurality of adjacent through-holes TH. According to the embodiment, it is possible to easily connect an external electrode even on the first surface 111 of the base substrate 110 in which through-holes are formed with a diameter in units of nm or a distance between center points in units of nm.

More specifically, as shown in FIGS. 7 to 12, according to an embodiment of the present invention, a first electrode layer 120 is disposed on the first surface 111 and the second surface 112 of the base 110, and inner wall surfaces of a plurality of through-holes TH2; a first dielectric layer 130 is disposed on the first electrode layer 120 on the first surface 111 and the second surface 112 of the base 110, and the inner wall surfaces of the plurality of through-holes TH2; a second electrode layer 140 is disposed on the first dielectric layer 130 on the first surface 111 and the second surface 112 of the base 110, and the inner wall surfaces of the plurality of through-holes TH2; a first electrode pad 150 is connected to the first electrode layer 120; and a second electrode pad 160 is connected to the second electrode layer 140.

The capacitance of the capacitor may follow Equation 1 below.

【Equation 1】

$$C = \varepsilon \frac{S}{d}$$

In Equation 1 above, C is capacitance, $\varepsilon$ is permittivity, S is an area of an electrode layer, and d is a distance between electrode layers. Accordingly, the capacitance may increase as the area of the electrode layer increases.

In this case, the first electrode layer 120 may include at least one of titanium (Ti), molybdenum (Mo), tungsten (W), or indium-tin. For example, the first electrode layer 120 may include at least one of TiN, $TiO_2$, $MoO_x$, $WO_x$, ITO, or ITGO, where x is a positive integer.

As such, when the first electrode layer 120 is disposed on the first surface 111, the second surface 112 of the base 110, and the inner wall surfaces of the through-holes TH2, the specific surface area of the capacitor increases, and accordingly, high capacitance may be obtained. In addition, since gas may flow through the through-holes TH2 during the deposition process of the first electrode layer 120, easy and uniform deposition may be achieved.

Next, the first dielectric layer 130 may include at least one of $SiO_2$, $Si_3N_3$, $SiN_4$, ZAZ, $HfO_2$, $ZrO_2$, $Hf_xZr_yO_z$, or $Al_2O_3$, where x, y, and z are positive integers. When the material of the first dielectric layer 130 satisfies these conditions, it is easy to deposit the first dielectric layer 130 with a uniform thickness on the first electrode layer 120.

Next, the second electrode layer 140 may include at least one of titanium (Ti), molybdenum (Mo), tungsten (W), indium-tin, copper (Cu), or aluminum (Al). For example, the second electrode layer 140 may include at least one of TiN, $TiO_2$, $MoO_x$, $WO_x$, ITO, ITGO, Cu, or Al, where x is a positive integer.

The material of the second electrode layer 140 may be the same as the material of the first electrode layer 120, but is not limited thereto. In other words, the material of the second electrode layer 140 may be different from the material of the first electrode layer 120. For example, the first electrode layer 120 may be deposited by at least one of titanium (Ti), molybdenum (Mo), tungsten (W), or indium-tin, and the second electrode layer 140 may be plated by Cu or Al.

In this case, the first electrode layer 120 is disposed on the edge of the upper surface 610 and the side surface 630 of the base electrode 600, the first dielectric layer 130 is disposed on the first electrode layer 120, and the second electrode layer 140 is disposed on the first dielectric layer 130. Here, the first electrode layer 120 is in direct contact with the edge of the upper surface 610 and the side surface 630 of the base electrode 600, and the first electrode pad 150 is disposed on the upper surface 610 of the base electrode 600. According to the embodiment, it is possible to easily dispose the first electrode pad 150 without a complicated process on the first surface 111 of the base substrate 110 in which through-holes are formed with a diameter in units of nm or a distance between center points in units of nm, and the first electrode layer 120 may be electrically directly connected to the first electrode pad 150 through the base electrode 600.

Here, the base electrode 600 may include the same material as the first electrode layer 120 or may include a different material. For example, the base electrode 600 may include at least one of chromium (Cr), copper (Cu), titanium (Ti), aluminum (Al), silver (Ag), or gold (Au), and may be disposed on the first surface 111 of the base substrate 110 by a deposition method. The base electrode 600 may be deposited on the first surface 111 of the base substrate 110 by a physical vapor deposition (PVD) or a chemical vapor deposition (CVD).

According to an embodiment of the present invention, the capacitor 100 further includes an insulating layer 400 disposed on the second electrode layer 140, and the insulating layer 400 extends from an upper surface of the second electrode layer 140 along a side surface of the second electrode layer 140, a side surface of the first dielectric layer 130, and a side surface of the first electrode layer 120 to an upper surface 610 of the base electrode 600 to be disposed between a side surface of the first electrode pad 150 and the side surface of the first electrode layer 120, the side surface of the first dielectric layer 130, and the side surface of the second electrode layer 140. According to the embodiment, the first electrode layer 120 is electrically connected to the first electrode pad 150 through the base electrode 600, while the second electrode layer 140 may be electrically insulated from the first electrode pad 150 by the insulating layer 400.

Meanwhile, according to an embodiment of the present invention, the capacitor 100 further includes a second electrode pad 160 that is disposed on the second electrode layer 140 and electrically connected to the second electrode layer 140. When a region of the first surface 111 of the base substrate 110 in which the base electrode 600 is disposed, is referred to as a first region 111A, a region of the first surface 111 of the base substrate 110 excluding the first region, that is, a region around the first region may be referred to as a second region. In other words, when n region of the first surface 111 of the base substrate 110 in which the base electrode 600 is disposed is referred to as a first region, a region of the first surface 111 of the base substrate 110 in which the base electrode 600 is not disposed may be referred to as a second region. According to an embodiment of the present invention, the second electrode pad 160 is disposed on the first electrode layer 120, the first dielectric layer 130, and the second electrode layer 140 that are sequentially disposed in the second region. As described above, the insulating layer 400 is disposed on the second electrode layer 140. To electrically connect the second electrode layer 140 and the second electrode pad 160, an opening may be formed in the insulating layer 400 disposed in the second region, and the second electrode pad 160 may be disposed in the opening so as to be in direct contact with the second electrode layer 140.

According to an embodiment of the present invention, a thickness of the base electrode 600 may be 0.9 to 1.1 times, preferably 0.95 to 1.05 times, and more preferably 0.975 to 1.025 times the sum of the thicknesses of the first electrode layer 120, the first dielectric layer 130, and the second electrode layer 140 disposed in the second region. According to the embodiment, the first electrode pad 150 and the second electrode pad 160 may be disposed to have the same height based on the first surface 111 of the base substrate 110. According to the embodiment, when the capacitor 100 according to an embodiment of the present invention is mounted on a printed circuit board, since separate adjustment of the heights of the first electrode pad 150 and the second electrode pad 160 is not required, an assembly process may be improved, and furthermore, bonding force between the first electrode pad 150 and the second electrode pad 160 and the printed circuit board may be improved.

To achieve this, the thickness of the base electrode 600 may be 10 nm to 100 $\mu$m, preferably 10 nm to 50 $\mu$m, and more preferably 10 nm to 10 $\mu$m. According to the embodiment, when the capacitor 100 is mounted on a printed circuit board while stably supporting the first electrode pad 150 disposed on the base electrode 600 bonding force with the printed circuit board may be kept high.

According to an embodiment of the present invention, in a state where the base electrode 600 is disposed on the first surface 111 of the base substrate 110, a material of the first electrode layer 120 may be deposited, such that the first electrode layer 120 is disposed on the upper surface and the side surface of the base electrode 600, the surface of the base substrate 110, and the inner wall surface of the through-holes TH2. The first electrode layer 120 may be deposited using, for example, an atomic layer deposition (ALD) process. When the ALD process is used, the material of the first electrode layer 120 may be conformally deposited in atomic units on the upper surface and the side surface of the base electrode 600, the surface of the base substrate 110, and the inner wall surface of the through-holes TH2. Accordingly, the first electrode layer 120 may be uniformly deposited on the upper surface and the side surface of the base electrode 600, the surface of the base substrate 110, and the inner wall surface of the through-holes TH2.

Similarly, the first dielectric layer 130 may be deposited using, for example, an ALD process. According to the embodiment, the material of the first dielectric layer 130 may be conformally and uniformly deposited in atomic units on the surface of the first electrode layer 120.

In addition, the second electrode layer 140 may be deposited using, for example, an ALD process. According to the embodiment, the material of the second electrode layer 140 may be conformally deposited in atomic units on the surface of the first dielectric layer 130. Alternatively, the second electrode layer 140 may be formed on the first dielectric layer 130 by an electrolytic plating process. In this case, the second electrode layer 140 may include Cu or Al.

In addition, the insulating layer 400 may be disposed on the second electrode layer 140.

As described above, in a state where the base electrode 600 is disposed on the first surface 111 of the base substrate 110, since the first electrode layer 120, the first dielectric layer 130, the second electrode layer 130, and the insulating layer 400 are disposed, the through-holes TH1 disposed under the base electrode 600 are empty, and the remaining through-holes TH2, except for the through-holes TH1 disposed under the base electrode 600, may be filled with the first electrode layer 120, the first dielectric layer 130, the second electrode layer 130, and the insulating layer 400. For example, the first electrode layer 120, the first dielectric layer 130, the second electrode layer 130, and the insulating layer 400 may be sequentially disposed on inner wall surfaces of the remaining through-holes TH2 except for the through-holes TH1 disposed under the base electrode 600.

As such, when the insulating layer 400 is disposed on the second electrode layer 130, the thickness of the second electrode layer 130 may be kept constant, and thus a capacitor having uniform electrical characteristics may be provided. In addition, when the insulating layer 400 is disposed on the second electrode layer 130 and fills the inside of the through-holes TH2, even if the temperature of the capacitor 100 increases, the plurality of through-holes TH2 do not thermally expand, thereby providing a capacitor 100 with high reliability. Alternatively, the insulating layer 400 may serve as passivation. To achieve this, the insulating layer 400 may include $Al_2O_3$ or $SiO_2$, or may include a resin composition having heat insulation and electrical insulation performance.

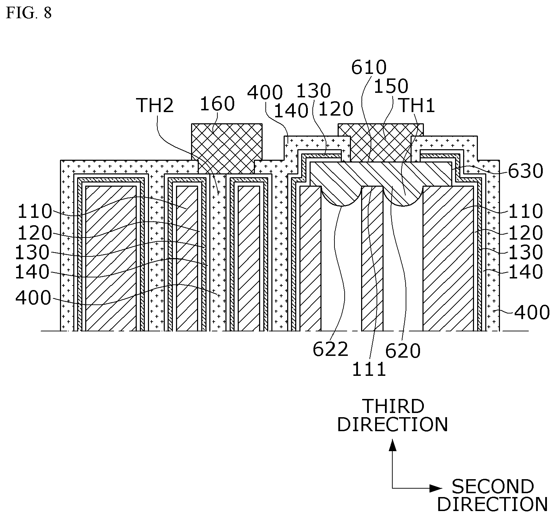

According to an embodiment of the present invention, as shown in FIG. 8, a lower surface 620 of the base electrode 600 may include a protrusion 622 that protrudes in a direction from the first surface 111 toward the second surface 112 within the through-holes TH in which the base electrode 600 is disposed. According to the embodiment, since the base electrode 600 is stably fixed to the base substrate 110, high reliability may be maintained even when the capacitor 100 is applied to an environment where shaking or vibration is frequent. At least one of a shape or a thickness of the protrusion 622 may vary depending on deposition process conditions or deposition materials of a PVD method or a CVD method.

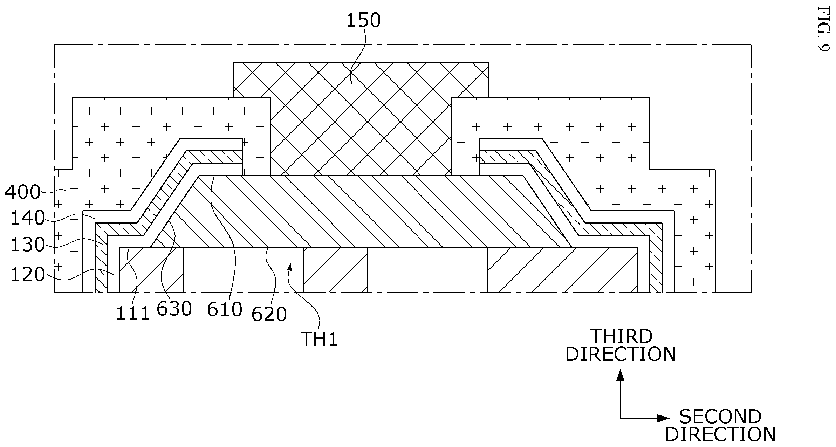

According to an embodiment of the present invention, as shown in FIG. 9, a side surface 630 of the base electrode 600 may be disposed to be inclined with respect to the first surface 111 of the base substrate 110. Here, being disposed to be inclined with respect to the first surface 111 of the base substrate 110 may mean that an angle between the first surface 111 of the base substrate 110 and the side surface 630 of the base electrode 600 is greater than 90 degrees and less than 180 degrees. For example, the angle between the first surface 111 of the base substrate 110 and the side surface 630 of the base electrode 600 may be greater than 90 degrees and less than 180 degrees, 100 degrees or more and 150 degrees or less, or 110 degrees or more and 130 degrees or less. The angle between the first surface 111 of the base substrate 110 and the side surface 630 of the base electrode 600 may vary depending on deposition process conditions or deposition materials of a PVD method or a CVD method for the base electrode 600. According to the embodiment, the first electrode layer 120 disposed on the side surface 630 of the base electrode 600 may also be disposed to be inclined with respect to the first surface 111 of the base substrate 110. Similarly, the first dielectric layer 130 and the second electrode layer 140 disposed on the side surface 630 of the base electrode 600 may also be disposed to be inclined with respect to the first surface 111 of the base substrate 110. According to the embodiment, since the areas of the first electrode layer 120, the first dielectric layer 130, and the second electrode layer 140 disposed on the side surface 630 of the base electrode 600 increase, capacitance may be enhanced, and bonding force between the side surface 630 of the base electrode 600 and the first electrode layer 120, the first dielectric layer 130, and the second electrode layer 140 may be increased. In addition, the first electrode layer 120, the first dielectric layer 130, and the second electrode layer 140 may be deposited with a uniform thickness at a boundary between the upper surface 610 and the side surface 630 of the base electrode 600 and at a boundary between the side surface 630 of the base electrode 600 and the first surface 111 of the base substrate 110. When the first electrode layer 120, the first dielectric layer 130, and the second electrode layer 140 are deposited with a uniform thickness, the resistance of the first electrode layer 120 and the second electrode layer 140 may be maintained uniformly, and uniform capacitance may be acquired.

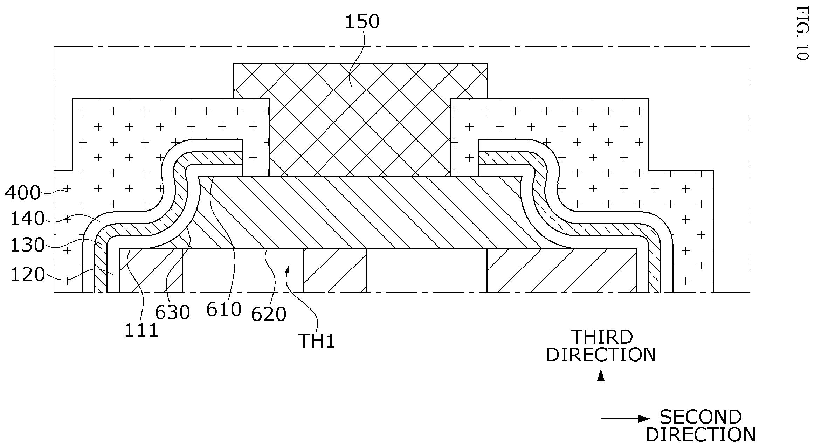

According to an embodiment of the present invention, as shown in FIG. 10, a side surface 630 of the base electrode 600 may include a concave region. A shape of the side surface 630 of the base electrode 600 may vary depending on deposition process conditions or deposition materials of a PVD method or a CVD method for the base electrode 600. According to the embodiment, the first electrode layer 120 disposed on the side surface 630 of the base electrode 600 may also be disposed along the concave region of the side surface 630 of the base electrode 600. Similarly, the first dielectric layer 130 and the second electrode layer 140 disposed on the side surface 630 of the base electrode 600 may also be disposed along the concave region of the side surface 630 of the base electrode 600. According to the embodiment, since areas of the first electrode layer 120, the first dielectric layer 130, and the second electrode layer 140 disposed on the side surface 630 of the base electrode 600 increase, capacitance may be increased, and bonding force between the side surface 630 of the base electrode 600 and the first electrode layer 120, the first dielectric layer 130, and the second electrode layer 140 may be increased. In addition, the first electrode layer 120, the first dielectric layer 130, and the second electrode layer 140 may be deposited with a uniform thickness at a boundary between the upper surface 610 and the side surface 630 of the base electrode 600 and at a boundary between the side surface 630 of the base electrode 600 and the first surface 111 of the base substrate 110.

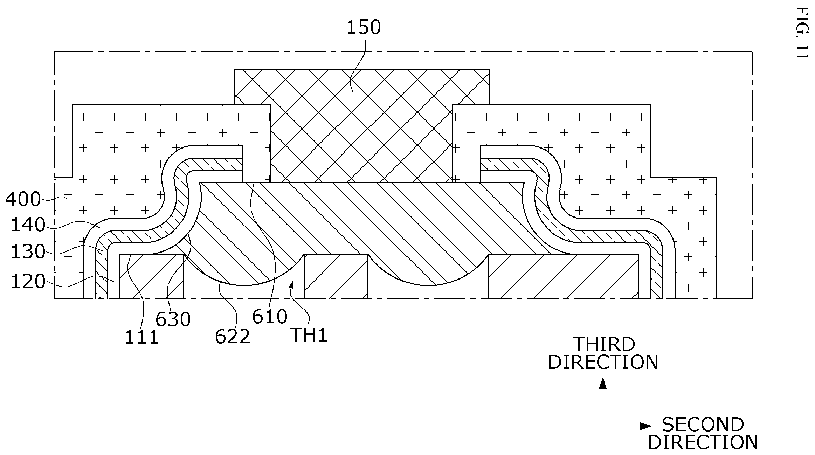

According to an embodiment of the present invention, as shown in FIG. 11, the side surface 630 of the base electrode 600 may include a concave region, and a lower surface 620 of the base electrode 600 may include a protrusion 622 that protrudes from the first surface 111 toward the second surface 112 in the through-holes TH1. Although not shown, the side surface 630 of the base electrode 600 may be disposed to be inclined with respect to the first surface 111 of the base substrate 110, and the lower surface 620 of the base electrode 600 may include a protrusion 622 that protrudes from the first surface 111 toward the second surface 112 in the through-holes TH.

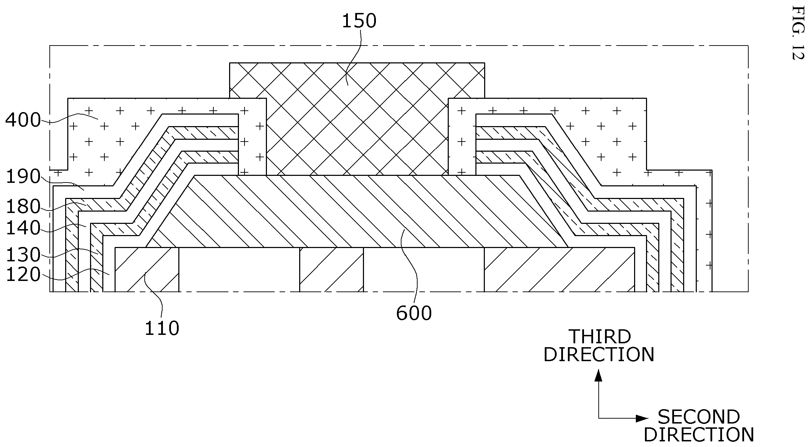

According to an embodiment of the present invention, as shown in FIG. 12, a dielectric layer and an electrode layer may be alternately and additionally disposed on the second electrode layer 140. A second dielectric layer 180 is disposed on the second electrode layer 140.

In this case, the second dielectric layer 180 may include at least one of $SiO_2$, $Si_3N_3$, $SiN_4$, ZAZ, $HfO_2$, $ZrO_2$, $Hf_xZr_yO_z$, or $Al_2O_3$, where x, y, and z are positive integers. When the material of the second dielectric layer 180 satisfies these conditions, it is easy to deposit the second dielectric layer 140 with a uniform thickness on the second electrode layer 140.

Next, a third electrode layer 190 is disposed on the second dielectric layer 180.

In this case, the third electrode layer 190 may include at least one of titanium (Ti), molybdenum (Mo), tungsten (W), indium-tin, copper (Cu), or aluminum (Al). For example, the third electrode layer 190 may include at least one of TiN, $TiO_2$, $MoO_x$, $WO_x$, ITO, ITGO, Cu, or Al, where x is a positive integer.

The material of the third electrode layer 190 may be the same as the material of the first electrode layer 120

and the second electrode layer 140, but is not limited thereto. In other words, the material of the third electrode layer 190 may be different from the material of the first electrode layer 120 and the second electrode layer 140. For example, the first electrode layer 120 and the second electrode layer 140 may include titanium (Ti), molybdenum (Mo), tungsten (W), and indium-tin, and the third electrode layer 190 may include Cu or Al.

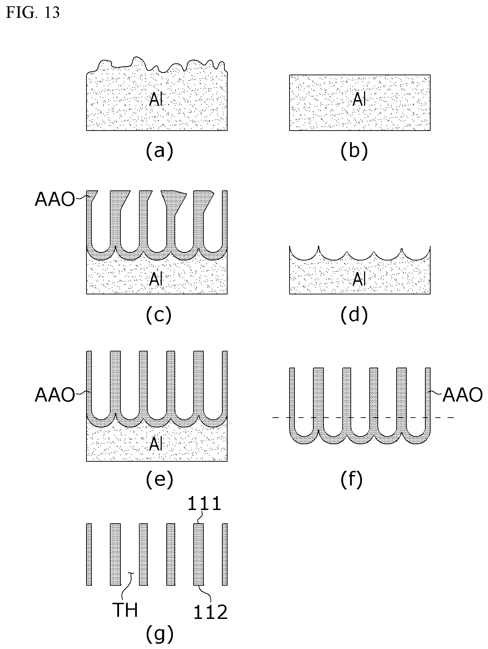

FIG. 13 is an example of a manufacturing method of a base substrate according to an embodiment of the present invention.

Referring to FIG. 13(a), an aluminum substrate is prepared. Here, the aluminum substrate may be an aluminum substrate containing 90% or more, preferably 99% or more, and more preferably 99.999% or more of aluminum. In this case, the aluminum substrate may have a rough surface.

Referring to FIG. 13(b), the surface of the aluminum substrate is electrochemically polished. Accordingly, the surface of the aluminum substrate may be planarized.

Referring to FIG. 13(c), a primary anodization process is performed on the surface of the planarized aluminum substrate. Accordingly, AAO may grow on the aluminum substrate. In this case, the AAO may grow through a wet process. According to the embodiment, AAO having pores of a predetermined width may grow on the aluminum substrate. In this case, the AAO grown by the primary anodization process may not be uniform.

Referring to FIG. 13(d), the AAO on the aluminum substrate is removed through wet etching.

Referring to FIG. 13(e), a secondary anodization process is performed on the aluminum substrate from which the AAO grown by the primary anodization process has been removed. Accordingly, AAO may grow more uniformly on the aluminum substrate than the AAO grown during the primary anodization process. In this case, by controlling the solvent, temperature, time, and voltage of the secondary anodization process, the pore size of the AAO, the length of the AAO, and the like may be adjusted.

Referring to FIG. 13(f), the aluminum substrate is removed via wet etching.

Referring to FIG. 13(g), the lower portion of the AAO, in other words, a region in contact with the aluminum substrate, is removed through wet etching.

Accordingly, the base substrate 110 including the plurality of through-holes TH penetrating from the first surface 111 to the second surface 112 may be provided.

Thereafter, the base electrode 600 is disposed on the first surface 111 of the base substrate 110; the first electrode layer 120, the first dielectric layer 130, and the second electrode layer 140 are sequentially deposited; the insulating layer 400 is disposed; the first electrode pad 150 is connected onto the base electrode 600 electrically connected to the first electrode layer 120; and the second electrode pad 160 is connected onto the second electrode layer 140.

Herein, the description is provided mainly with respect to the manufacturing method of a capacitor in which the base includes AAO, but embodiments of the present invention are not limited thereto. The capacitor according to an embodiment of the present invention may also be a silicon-based capacitor in which the base includes silicon.

Although the foregoing description has been provided with reference to exemplary embodiments of the present invention, it will be understood by those or ordinary skill in the art that various modifications and changes may be made without departing from the spirit and scope of the present invention set forth in the appended claims.

**Claims**

1. A capacitor comprising:

   a base substrate including a plurality of through-holes penetrating from a first surface to a second surface opposite to the first surface;
   a base electrode disposed on the first surface to cover at least two adjacent through-holes among the plurality of through-holes;
   a first electrode layer disposed on an upper surface edge and a side surface of the base electrode;
   a dielectric layer disposed on the first electrode layer;
   a second electrode layer disposed on the dielectric layer;
   an insulating layer disposed on the second electrode layer; and
   a first electrode pad disposed on an upper surface of the base electrode,
   wherein the insulating layer extends from an upper surface of the second electrode layer along a side surface of the second electrode layer, a side surface of the dielectric layer, and a side surface of the first electrode layer to the upper surface of the base electrode, and is disposed between a side surface of the first electrode pad and the side surface of the first electrode layer, the side surface of the dielectric layer, and the side surface of the second electrode layer.

2. The capacitor of claim 1, wherein a side surface of the base electrode is disposed to be inclined with respect to the first surface, and
   the first electrode layer disposed on the side surface of the base electrode is disposed to be inclined with respect to the first surface.

3. The capacitor of claim 1, wherein the side surface of the base electrode includes a concave region, and

the first electrode layer is disposed along the concave region on the side surface of the base electrode.

4. The capacitor of claim 1, wherein a lower surface of the base electrode includes a protrusion protruding in a direction from the first surface toward the second surface within the at least two through-holes.

5. The capacitor of claim 1, wherein the at least two through-holes disposed under the base electrode are empty.

6. The capacitor of claim 5, wherein remaining through-holes of the plurality of through-holes, excluding the at least two through-holes, are filled by the first electrode layer, the dielectric layer, the electrode layer, and the insulating layer.

7. The capacitor of claim 6, wherein the first electrode layer, the dielectric layer, the second electrode layer, and the insulating layer are sequentially disposed on an inner wall surface of the remaining through-holes of the plurality of through-holes, excluding the at least two through-holes.

8. The capacitor of claim 1, wherein the first electrode layer, the dielectric layer, and the second electrode layer are sequentially disposed on the first surface of the base substrate in a second region around a first region in which the base electrode is disposed, and further comprises a second electrode pad disposed on the second electrode layer in the second region.

9. The capacitor of claim 8, wherein a thickness of the base electrode is 0.9 to 1.1 times a thickness of the first electrode layer, the dielectric layer, and the second electrode layer disposed in the second region.

10. The capacitor of claim 1, wherein the base substrate is an anodized substrate of at least one of aluminum (Al), magnesium (Mg), zinc (Zn), titanium (Ti), tantalum (Ta), hafnium (Hf), or niobium (Nb).

FIG. 1

FIG. 2

<u>110</u>

FIG. 3

FIRST
DIRECTION

SECOND
DIRECTION

111

FIG. 4

FIG. 5

FIRST
DIRECTION

SECOND
DIRECTION

FIG. 6

600:610, 620, 630

THIRD
DIRECTION

SECOND
DIRECTION

FIG. 7

THIRD
DIRECTION

SECOND
DIRECTION

FIG. 8

THIRD
DIRECTION

SECOND
DIRECTION

FIG. 9

FIG. 10

FIG. 11

FIG. 12

FIG. 13

(a)

(b)

AAO

(c)

(d)

AAO

(e)

AAO

(f)

111

TH          112

(g)

## INTERNATIONAL SEARCH REPORT

| | International application No. |
|---|---|
| | **PCT/KR2024/012792** |

### A. CLASSIFICATION OF SUBJECT MATTER

**H10N 97/00**(2023.01)i; **H01L 27/13**(2006.01)i; **H01L 27/08**(2006.01)i

According to International Patent Classification (IPC) or to both national classification and IPC

### B. FIELDS SEARCHED

Minimum documentation searched (classification system followed by classification symbols)

H10N 97/00(2023.01); H01G 4/12(2006.01); H01G 4/228(2006.01); H01G 4/33(2006.01); H01L 21/8242(2006.01); H01L 27/108(2006.01); H01L 49/02(2006.01); H05K 1/11(2006.01); H05K 3/46(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 캐패시터(capacitor), 전극층(electrode layer), 유전체(dielectric), 금속층(metal layer), 관통 구멍(through hole)

### C. DOCUMENTS CONSIDERED TO BE RELEVANT

| Category* | Citation of document, with indication, where appropriate, of the relevant passages | Relevant to claim No. |
|---|---|---|
| Y | JP 2020-027821 A (TAIYO YUDEN CO., LTD.) 20 February 2020 (2020-02-20)<br>See paragraphs [0026], [0030], [0035] and [0040]-[0047]; and figure 2. | 1,5-10 |
| A | | 2-4 |
| Y | JP 2018-195766 A (DAINIPPON PRINTING CO., LTD.) 06 December 2018 (2018-12-06)<br>See paragraphs [0032], [0037]-[0042] and [0057]-[0061]; and figures 1-3. | 1,5-10 |
| A | KR 10-2019-0033239 A (SAMSUNG ELECTRO-MECHANICS CO., LTD.) 29 March 2019 (2019-03-29)<br>See paragraphs [0031]-[0041]; and figures 1-8. | 1-10 |
| A | KR 10-2013-0132519 A (TESSERA, INC.) 04 December 2013 (2013-12-04)<br>See paragraphs [0027]-[0047]; and figure 1a. | 1-10 |

☑ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **29 November 2024** | **29 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
|---|
| **PCT/KR2024/012792** |

### C.    DOCUMENTS CONSIDERED TO BE RELEVANT

| Category* | Citation of document, with indication, where appropriate, of the relevant passages | Relevant to claim No. |
|---|---|---|
| A | JP 2018-182283 A (DAINIPPON PRINTING CO., LTD.) 15 November 2018 (2018-11-15)<br>See paragraphs [0035]-[0082]. | 1-10 |

## INTERNATIONAL SEARCH REPORT
### Information on patent family members

| | International application No. |
|---|---|
| | **PCT/KR2024/012792** |

| Patent document cited in search report | | | Publication date (day/month/year) | Patent family member(s) | | | Publication date (day/month/year) |
|---|---|---|---|---|---|---|---|
| JP | 2020-027821 | A | 20 February 2020 | JP | 7160594 | B2 | 25 October 2022 |
| | | | | US | 11309134 | B2 | 19 April 2022 |
| | | | | US | 2020-0051749 | A1 | 13 February 2020 |
| JP | 2018-195766 | A | 06 December 2018 | JP | 7068638 | B2 | 17 May 2022 |
| KR | 10-2019-0033239 | A | 29 March 2019 | CN | 109545778 | A | 29 March 2019 |
| | | | | CN | 109545778 | B | 09 September 2022 |
| | | | | CN | 115360175 | A | 18 November 2022 |
| | | | | JP | 2019-057703 | A | 11 April 2019 |
| | | | | JP | 7259173 | B2 | 18 April 2023 |
| | | | | US | 10811193 | B2 | 20 October 2020 |
| | | | | US | 2019-0088419 | A1 | 21 March 2019 |
| KR | 10-2013-0132519 | A | 04 December 2013 | CN | 103348442 | A | 09 October 2013 |
| | | | | CN | 103348442 | B | 22 March 2017 |
| | | | | CN | 103348443 | A | 09 October 2013 |
| | | | | CN | 103348443 | B | 22 March 2017 |
| | | | | CN | 107045972 | A | 15 August 2017 |
| | | | | CN | 107045972 | B | 05 May 2020 |
| | | | | EP | 2649639 | A1 | 16 October 2013 |
| | | | | EP | 2649639 | B1 | 01 September 2021 |
| | | | | EP | 2649640 | A1 | 16 October 2013 |
| | | | | EP | 2649640 | B1 | 17 August 2022 |
| | | | | EP | 4102585 | A2 | 14 December 2022 |
| | | | | EP | 4102585 | A3 | 22 March 2023 |
| | | | | JP | 2014-505354 | A | 27 February 2014 |
| | | | | JP | 2014-506001 | A | 06 March 2014 |
| | | | | JP | 2016-157946 | A | 01 September 2016 |
| | | | | JP | 5895000 | B2 | 30 March 2016 |
| | | | | JP | 6329977 | B2 | 23 May 2018 |
| | | | | KR | 10-1108947 | B1 | 08 February 2012 |
| | | | | KR | 10-1188918 | B1 | 08 October 2012 |
| | | | | KR | 10-2012-0064610 | A | 19 June 2012 |
| | | | | KR | 10-2012-0064611 | A | 19 June 2012 |
| | | | | TW | 201232580 | A | 01 August 2012 |
| | | | | TW | 201232581 | A | 01 August 2012 |
| | | | | TW | 201430885 | A | 01 August 2014 |
| | | | | TW | I479522 | B | 01 April 2015 |
| | | | | TW | I479523 | B | 01 April 2015 |
| | | | | TW | I546833 | B | 21 August 2016 |
| | | | | US | 10157978 | B2 | 18 December 2018 |
| | | | | US | 11004930 | B2 | 11 May 2021 |
| | | | | US | 2012-0146182 | A1 | 14 June 2012 |
| | | | | US | 2012-0181658 | A1 | 19 July 2012 |
| | | | | US | 2013-0313680 | A1 | 28 November 2013 |
| | | | | US | 2014-0273393 | A1 | 18 September 2014 |
| | | | | US | 2016-0079189 | A1 | 17 March 2016 |
| | | | | US | 2016-0315139 | A1 | 27 October 2016 |
| | | | | US | 2019-0131387 | A1 | 02 May 2019 |
| | | | | US | 2021-0265460 | A1 | 26 August 2021 |
| | | | | US | 8502340 | B2 | 06 August 2013 |
| | | | | US | 8742541 | B2 | 03 June 2014 |

Form PCT/ISA/210 (patent family annex) (July 2022)

**INTERNATIONAL SEARCH REPORT**
Information on patent family members

International application No.

**PCT/KR2024/012792**

| Patent document cited in search report | | | Publication date (day/month/year) | Patent family member(s) | | | Publication date (day/month/year) |
|---|---|---|---|---|---|---|---|
| | | | | US | 9190463 | B2 | 17 November 2015 |
| | | | | US | 9431475 | B2 | 30 August 2016 |
| | | | | US | 9437557 | B2 | 06 September 2016 |
| | | | | WO | 2012-078213 | A1 | 14 June 2012 |
| | | | | WO | 2012-079013 | A1 | 14 June 2012 |
| JP | 2018-182283 | A | 15 November 2018 | JP | 2022-028847 | A | 16 February 2022 |
| | | | | JP | 2023-120327 | A | 29 August 2023 |
| | | | | JP | 6982794 | B2 | 17 December 2021 |
| | | | | JP | 7298667 | B2 | 27 June 2023 |

Form PCT/ISA/210 (patent family annex) (July 2022)